# EUROPÄISCHE PATENTSCHRIFT

(11) **EP 1 270 507 B1**
(45) Veröffentlichungstag und Bekanntmachung des Hinweises auf die Patenterteilung: **19.07.2006**
(21) Anmeldenummer: 01128680.4
(22) Anmeldetag: 01.12.2001
(51) Int. Cl.: B81B 7/00

(54) **Passivieren anodischer Bondgebiete bei mikro-elektromechanischen Systemen**
Passivation of anodic bonding regions in microelectromechanical systems
Passivation des régions de collage dans des systémes microélectromécaniques

(30) Priorität: 13.06.2001 DE 10129821
(43) Veröffentlichungstag der Anmeldung: 02.01.2003
(73) Patentinhaber: X-FAB Semiconductor Foundries AG, 99097 Erfurt (DE)
(72) Erfinder: Knechtel, Roy, Dr., 98716 Geraberg (DE); Freywald, Karlheinz, 99086 Erfurt (DE)
(74) Vertreter: Leonhard, Frank Reimund

(56) Entgegenhaltungen:
- EP-A- 0 280 905
- EP-A- 0 500 234
- GB-A- 1 283 769
- US-A- 4 023 562
- US-A- 6 058 781

## Beschreibung

Die Erfindung betrifft ein Verfahren zur Herstellung und eine Anordnung eines Mehrschichtsystems zur Passivierung von mikroelektromechanischen Systemen, speziell zur Passivierung von anodischen Bondgebieten, die über elektrisch aktive Strukturen angeordnet sind, und gleichermaßen zur Verbindung der Silizium-Prozessscheibe (Si-Wafer) mit einem Glaskörper (glass wafer) durch anodisches Bonden bei der Herstellung von integrierten elektrischen mikromechanischen Systemen.

Zum Schutz von diskreten Halbleiterbauelementen und integrierten Schaltkreisen sind Passivierungsschichten, einzelne und mehrfach übereinander liegende Beschichtungen seit vielen Jahren bekannt. Zweck dieser Schichten ist der hermetische Abschluss der Bauelementestrukturen gegenüber verschiedenen Umgebungseinflüssen. Als solche Einflüsse kommen u. A. ionische Verunreinigungen in Frage, die während der Herstellung auftreten oder während der Montage, der Lagerung oder des Bauelementebetriebes einwirken können, welche die elektrischen Parameter negativ beeinflussen und insbesondere deren Langzeitstabilität verringern.

**EP-A 827 199** beschreibt z.B. ein Passivierungsschichtsystem für HalbleiterBauelemente, welches aus zwei Schichten besteht. Eine erste SiON-Schicht befindet sich im direkten Kontakt mit der Oberfläche des Halbleiterbauelements, eine zweite, darüber befindliche Schicht ist eine Si₃N₄-Schicht.

Passivierungsschichten sind auch bei mikroelektromechanischen Bauelementen bekannt. Dem Stand der Technik entsprechend handelt es sich dabei um relativ einfache Schichten, bzw. Schichtsysteme.

Für den Fall, dass passivierte Si-Wafer mit einem Glaswafer (Glaskörper) verbunden werden sollen, darf die durchgehend vorhandene Passivierungsschicht den anodischen Bondprozess nicht negativ beeinflussen. Dadurch ist die Vielfalt der möglichen Passivierungsschichten stark eingeschränkt.

In **US-A 6,058,781** (Kusuyama) wird ein dreilagiger Aufbau eines Drucksensors beschrieben, der sich unter einer Glassabdeckplatte befindet. Diese dreilagige Schichtabfolge ist mehr ein Ergebnis des technologischen Ablaufs der Herstellung der elektrischen und mechanischen Funktionselemente, als ein gezielt eingesetzter Schutz gegen eine Beeinträchtigung dieser Strukturen beim Aufbringen einer Glasdeckplatte. Die unterste PSG-Schicht (102) wird bei Kusuyama in ihrer Funktion nicht näher beschrieben, vgl. Spalte 24, Zeilen 12 bis 22 und Spalte 21, Zeilen 38 bis 62. Die mittlere Schicht (111) dient als Isolatorschicht, vgl. dort Spalte 23, Zeilen 31 bis 40. Als Material für diese Schicht wird Siliziumdioxid vorgeschlagen, welches keine Barrierewirkung hinsichtlich beweglicher Ionen besitzt. Die dritte Schicht (113) wird bei Kusuyama als dünne Schutzschicht ausgeführt, vgl. dort Spalte 23, Zeilen 52 bis 58. Dies weist darauf hin, dass die beiden ersten Schichten nicht Teil der schützenden Passivierung sind. Es gibt keinen Hinweis darauf, dass diese letzte Schicht notwendig oder hilfreich für das Aufbringen einer Glasplatte 114 ist. In der Silizium-Planartechnik Kommt es häufig zu sehr ähnlichen Schichtabfolgen, die aufgrund ihrer konkreten Eigenschaften oder Ausbildung (Schichtdicken, Zusammensetzung, Erzeugung) sehr unterschiedliche Funktionen erfüllen.

Siliziumnitrid wird tatsächlich aus sehr vielen unterschiedlichen Gründen in Halbleitertechnologien verwendet. In **EP-A 500 234** (Honeywell), dort Spalte 9, Z.42 wird Siliziumnitrid nicht als Zwischenschicht verwendet, sondern als dortige Deckschicht 59.

Zum Verbinden zweier Körper durch anodisches Bonden müssen deren Oberflächen bestimmten Anforderungen genügen. Teilweise werden auch gezielt Zwischenschichten eingesetzt. Neben dem Verbinden von massiven Borsilikatglas-Körpem mit Silizium, vgl. **EP-A 280 905** sind auch Schichten aus diesem Glas, vgl. **US-A 4,802,952,** und SiO₂-Schichten, vgl. **US-A 4,295,115** zum Verbinden zweier Si-Körper beim anodischen Bonden bekannt. Bekannt ist ferner das Verbinden eines Glaskörpers mit einem Siliziumkörper durch anodisches Bonden, wenn der Siliziumkörper mit einer Passivierungsschicht aus SiO₂ oder Si₃N₄ versehen ist, vgl. US-A 5,591,679, bzw. wenn die Passivierungsschicht wieder mit einer Si-Schicht überdeckt wurde, vgl. US-A 4,295,115 und US-A 4,291,239. Es sind somit einige einfache und mehrschichtige Belegungen bekannt, die für den anodischen Bondprozess, vorzugsweise Si/ Glas geeignet sind.

Die Zielrichtung dieser mikroelektromechanischen Entwicklungen war jedoch durch die Anforderungen der anodischen Bondverbindung nach hermetischer Dichtigkeit und deren Beständigkeit gegen chemische Medien und Temperatur- sowie Druckeinflüsse geprägt, siehe DE-A 39 37 529 und sind nicht optimiert für die Überbondung von elektrisch aktiven Gebieten, speziell von Anschlussbahnen bei Erhalt ihrer geforderten positiven elektrischen Eigenschaften.

Die fortgeschrittene Entwicklung auf diesem Gebiet ist durch Chips gekennzeichnet, die innerhalb einer hermetisch dichten Kavität mechanische und elektrische Funktionen vereinigen und somit eine hochwertige elektrische Kontaktierung durch den hermetisch dichten Bondbereich (durch anodisches Bonden) hindurch zu den außen liegenden Schaltungsstrukturen erfordern. Bekannt ist z.B. die sehr aufwendige Realisierung solcher elektrischen Durchführungen für den Einsatz bei Druck- und Beschleunigungssensoren in Form von Diffusionsgebieten, die unter einer nachträglich abgeschiedenen Silizium-Epitaxieschicht liegen, vgl. **US-A 5,591,679.** In US-A 4,291,293 werden für das anodische Überbonden von elektrischen Leitungen in Form von Diffusionsgebieten Mehrfachschichten ohne eine wirksame Diffusionsbarriere gegenüber Natrium-Ionen vorgeschlagen.

Die beschriebene Notwendigkeit zur Erzeugung von elektrischen Kontaktierungen durch ein anodisch gebondetes Gebiet hindurch ist von größter Bedeutung bei der Herstellung von hermetisch geschlossenen MEMS, sowohl als Einzelchips wie auch zunehmend als integriertes System, wo Sensor und eine CMOS Schaltung auf demselben Chip angeordnet sind und zusammen gefertigt werden.

Der Erfindung liegt die Aufgabe zu Grunde, eine Passivierungsmethode anzugeben, die mit der Herstellung nur eines entsprechenden Isolatorschichtsystems die anodische Bondbarkeit zur Erzeugung hermetisch dichter Kavitäten erreicht, gleichermaßen eine Schädigung der unter dem Bondgebiet befindlichen elektrischen Kontaktleitungen in Form von Diffusionsgebieten verhindert und weiterhin eine hohe Langzeitstabilität bietet. Zweck der Erfindung ist die Verbesserung der Langzeitstabilität von mikroelektromechanischen Bauelementechips mit einem kostengünstigen Fertigungsverfahren.

Die Aufgabe wird erfindungsgemäß durch das Verfahren nach Anspruch 1 und die Passivierungs. Schichtsystem nach Anspruch 8 gelöst, in dem auf die Halbleiterscheibe, beispielsweise als Siliziumscheibe mit den erzeugten mikroelektromechanischen Sensorstrukturen und Schaltungseinheiten, welche Scheibe bereits mit einer Isolatorschicht versehen sein kann, vor dem anodischen Bondprozess ganzflächig eine erste Schicht abgeschieden wird, welche in der Lage ist, mobile lonen zu gettem. Auf diese wird eine zweite Schicht aufgebracht, welche die Eigenschaft besitzt, eine **Barriere für mobile lonen zu bilden. Darauf wird eine dritte Schicht hergestellt, welche** die anodische Bondbarkeit erreicht. Die Strukturierung dieser Mehrfachschicht erfolgt anschließend nur auf den Drahtbondinseln (Bondpads).

Im Bereich der Verbindungsgebiete der Scheibe mit der Deckscheibe sichert die obere, dritte Schicht das perfekte und sichere anodische Bonden bei erhöhter Temperatur unter elektrischer Vorspannung. Die mittlere Schicht verhindert infolge ihrer Barrierewirkung lonendrift-Prozesse, die insbesondere bei höheren Temperaturen aktiviert werden können. Sie schützt so die aktiven Gebiete der Schaltungen vor einer parasitären Ladungsbeeinflussung. Im Bereich des nach dem Bonden hermetisch abgeschlossenen Volumens (Kavität) verhindert der Gesamtaufbau der Passivierungsschicht die Schädigung von Metallleitungen oder Diffusionsgebieten durch elektrostatische Entladungen und die unterste, erste Schicht verhindert speziell eine laterale lonenbewegung bei erhöhter Temperatur. Im Bereich außerhalb der Glasdeckelung und der Kontaktiergebiete (Bondpads für das Drahtbonden) schützt die Passivierungsschicht wie gewöhnlich vor mechanischen Beschädigungen und vor dem Eindringen von Verunreinigungen in elektrisch aktive Gebiete. Dabei wirkt die untere Schicht zusätzlich als Getterschicht für mobile lonen von darunter befindlichen Strukturen (Anspruch 1).

Es wird also durch das beschriebene Passivierungsverfahren erreicht, dass elektrische Strukturen, z.B. pn-Übergänge, weder im technologischen Prozess noch später während der Lagerung oder Betriebszeit durch Einwirkung der Umgebung (Medien, Temperatur) beschädigt oder in ihrer Funktion gestört werden.

Die positiven mechanischen Eigenschaften der Bondverbindung, z.B. eine hermetische Dichtigkeit oder eine Temperaturbeständigkeit, bleiben ohne Einschränkung erhalten.

Die mit der erfindungsgemäßen Lösung erzielten Vorteile bestehen insbesondere in der Möglichkeit elektrisch aktive Schaltungen und mechanische Funktionen innerhalb einer hermetisch abgedichteten Kavität zu betreiben und durch die Bondgebiete hindurch von außen her anzuschließen.

Weitere Vorteile sind, dass die Schichten derart abscheidbar sind, dass eine nahezu stressfreie Passivierungsschicht entsteht, dass eine Verkapselung von mechanisch bewegten Strukturen auf Scheibenbasis erfolgen kann, und dass diese Verkapselung auch an komplett prozessierten Wafern zum Beispiel mit komplexen CMOS-Schaltungen möglich ist.

Nachfolgend soll die Erfindung anhand eines Ausführungsbeispiels näher erläutert werden. Es zeigen
- Figur 1: einen Querschnitt durch eine Halbleiterscheibe mit elektrischen Strukturen, die mit einer Deckscheibe aus Glas über ein Passivierungsschichtsystem durch anodisches Bonden verbunden ist, in schematischer Darstellung, mit einer Deckscheibe aus Borsilikatglas,
- Figur 2: die Einzelheit A aus Figur 1 zum Aufbau des Passivierungs-Schichtsystems, in schematischer Darstellung.
- Figur 3: die Einzelheit B aus Figur 1.

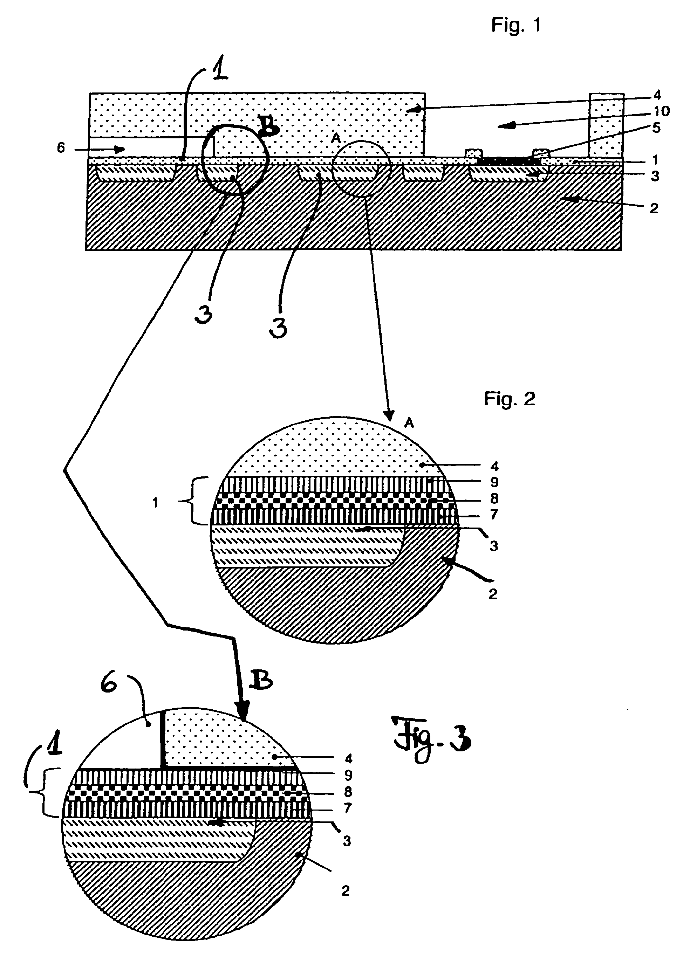

**In Figur 1** bedeckt die mehrlagige Passivierungsschicht 1 die durch Dotierung in die Halbleiterscheibe 2 eingebrachten elektrischen Strukturen 3. Der Glaskörper 4 ist über die Passivierungsschicht 1 mit der Halbleiterscheibe 2 durch ein anodisches Bonden verbunden worden. Die Passivierungsschicht 1 ist nur an den Drahtbondinseln aus Aluminium 5 so geöffnet, dass sie die Ränder der Bondinseln abdeckt.

Der Glaskörper 4 weist Aussparungen 6 und Öffnungen 10 auf. Die geschlossene Passivierungsschicht 1 schützt die elektrischen Strukturen 3 in den Bereichen A, in denen der Glaskörper 4 direkt über den Gebieten der elektrischen Strukturen 3 gebondet ist, in dem Bereich der jeweiligen Aussparung 6 (der so genannten Kavitäten) und in dem Bereich der Öffnungen des Glaskörpers 10.

**Figur 2** zeigt den Schichtaufbau der Passivierungsschicht 1 aus Figur 1 im Bereich A.

Eine mögliche, auf den elektrischen Strukturen vorhandene Isolierschicht ist in diesem Beispiel nicht dargestellt. Die erste, unterste Schicht 7 besteht aus Phosphorsilikatglas. Darauf befindet sich die mittlere Schicht 8 aus Siliziumnitrid. Die obere Schicht 9 ist eine CVD Oxidschicht, die mit dem Tetraetoxysilan-Verfahren (TEOS-Verfahren) erzeugt wurde.

### Bezugszeichenliste:

### Zu Figur 1

- 1:: Passivierungsschichtsystem
- 2:: Si-Halbleiterscheibe (Substrat)
- 3:: elektrische Strukturen (Diffusionsgebiete)
- 4:: Glaskörper, strukturiert
- 5:: Bondinsel für das Drahtbonden (Bondpad)
- 6:: Aussparung im Glaskörper (Kavität)
- 10:: Öffnung im Glaskörper (nach oben).

### Zu Figur 2

- 1:: Passivierungsschichtsystem
- 2:: Si-Halbleiterscheibe (Substrat)
- 3:: elektrische Strukturen (Diffusionsgebiete)
- 4:: Glaskörper, strukturiert
- 7:: Phosphorsilikatglasschicht: Erste Schicht von 1
- 8:: Siliziumnitridschicht als mittlere Schicht von 1
- 9:: TEOS-CVD-Oxidschicht als obere Schicht von 1

## Patentansprüche

1. **Verfahren** zum Passivieren eines mikroelektromechanischen Systems (MEMS) auf der Basis von Silizium (2) und Erzeugung hermetisch abgeschlossener Hohlräume (6) unter Verwendung eines flächigen Abdeckkörpers (4) aus Glas,
**dadurch gekennzeichnet, dass**
auf eine Halbleiterscheibe (2) mit fertig präparierten elektrischen Strukturen ein aus mindestens drei unterschiedlichen Schichten bestehendes Passivierungs-Schichtsystem (1) ganzflächig abgeschieden wird, wobei
- die erste (7) der abgeschiedenen Schichten geeignet ist, mobile lonen zu gettern;
- die zweite, als eine mittlere Schicht (8) geeignet ist, eine Barriere für mobile lonen zu bilden;
- die darüber befindliche, dritte Schicht (9) eine anodische Bondbarkeit erreicht;
anschließend die Halbleiterscheibe (2) mit dem flächigen Abdeckkörper (4) durch ein anodisches Bonden unter Vorhandensein dieses Passivierungs-Schichtsystems (1;7,8,9) zwischen den zu verbindenden Scheiben (2,4) zusammengefügt wird, und zumindest ein im Abdeckkörper (4) befindlicher Hohlraum (6) oberhalb der dritten der drei Schichten im wesentlichen hermetisch abgeschlossen wird.

2. Verfahren nach Anspruch 1, wobei die Abscheidung der Schichten des Passivierungs-Schichtsystems (1) auf eine Isolatorschicht erfolgt, die in vorangegangenen Prozessschritten erzeugt wurde.

3. Verfahren nach Anspruch 1, wobei der flächige Abdeckkörper (4) eine Abdeckscheibe aus Glas ist.

4. Verfahren nach Anspruch 1, wobei der flächige Abdeckflächenkörper (4) im Bereich zumindest einer Bondinsel (5) geöffnet wird (10) und nur Randbereiche der Bondinsel abgedeckt werden.

5. Verfahren nach Anspruch 4, wobei außerhalb der Bondinseln (5) der Abdeckflächenkörper (4) über das Schichtsystem (1) zur Passivierung gebondet ist und elektrische Strukturen (3) unter dem Schichtsystem (1) schützt (A, B).

6. Verfahren nach Anspruch 1, wobei eine Isolierschicht zwischen den elektrischen Strukturen (3) und dem Passivierungs-Schichtsystem (1) aufgebracht ist, bevor die erste Schicht (7) des Schichtsystems (1) abgeschieden wird.

7. Verfahren nach Anspruch 1, wobei eine Siliziumnitridschicht (8) zur Einstellung eines definierten Schichtstresses vorgesehen wird, und/oder die dritte Schicht (9) des Schichtsystems (1) eine durch ein TEOS-Verfahren erzeugte CVD Oxidschicht ist.

8. **Passivierungs-Schichtsystem**, herstellbar nach Anspruch 1, für ein mikroelektromechanisches System mit Schaltstrukturen (3), wobei das Schichtsystem drei übereinander liegende Schichten aufweist, mit einer ersten, den Schaltstrukturen (3) am nächsten befindlichen Schicht (7) aus Phosphorsilikatglas, einer mittleren Schicht (8) aus Siliziumnitrid und einer dritten Schicht (9) aus Siliziumoxid, um ein hermetisch dichtes, anodisches Bonden einer Abdeckscheibe (4) auf der oberen Schicht des Schichtsystems zu erlauben.

9. Passivierungs-Schichtsystem nach Anspruch 8, wobei die dritte Schicht eine CVD Oxidschicht ist, die durch ein TEOS-Verfahren erzeugt wurde.

10. Passivierungs-Schichtsystem nach Anspruch 8, wobei die Siliziumnitridschicht zur Einstellung eines definierten Schichtstresses vorgesehen ist.

## Claims

1. Process for passivating a microelectromechanical system (MEMS) based on silicon (2) and production of hermetically sealed cavities (6) using a laminar cover body (4) made from glass, **characterised in that** a passivating layer system (1) consisting of at least three different layers is deposited on the whole surface of a semiconductor wafer (2) with ready-prepared electrical structuring, wherein
- the first (7) of the deposited layers is suitable to getter mobile ions;
- the second, as a central layer (8), is suitable to form a barrier for mobile ions;
- the third layer (9) situated thereabove achieves anodic bondability;
then the semiconductor wafer (2) is integrated with the laminar cover body (4) by anodic bonding in the presence of this passivating layer system (1; 7, 8, 9) between the wafers (2, 4) to be joined, and at least one cavity (6) situated in the cover body (4) is sealed essentially hermetically above the third of the three layers.

2. Process according to claim 1, wherein deposition of the layers of the passivating layer system (1) takes place on an insulating layer, which has been produced in preceding process steps.

3. Process according to claim 1, wherein the laminar cover body (4) is a cover disc made from glass.

4. Process according to claim 1, wherein the laminar cover surface body (4) is opened (10) in the region of at least one bonding island (5) and only edge regions of the bonding island are covered.

5. Process according to claim 4, wherein outside of the bonding islands (5), the cover surface body (4) is bonded above the layer system (1) for passivation and protects (A, B) electrical structures (3) below the layer system (1).

6. Process according to claim 1, wherein an insulating layer is applied between the electrical structures (3) and the passivating layer system (1), before the first layer (7) of the layer system (1) is deposited.

7. Process according to claim 1, wherein a silicon nitride layer (8) is provided for adjusting a defined layer stress, and/or the third layer (9) of the layer system (1) is a CVD oxide layer produced by a TEOS process.

8. Passivating layer system which can be produced according to claim 1, for a microelectromechanical system with switch structures (3), wherein the layer system has three layers lying one above another, having a first layer (7) made from phosphorus silicate glass situated closest to the switch structures (3), a central layer (8) made from silicon nitride and a third layer (9) made from silicon oxide, in order to permit hermetically tight, anodic bonding of a cover disc (4) on the upper layer of the layer system.

9. Passivating layer system according to claim 8, wherein the third layer is a CVD oxide layer, which has been produced by a TEOS process.

10. Passivating layer system according to claim 8, wherein the silicon nitride layer is provided for adjusting a defined layer stress.

## Revendications

1. Procédé de passivation d'un microsystème électromécanique (MEMS), basé sur du silicium (2), et de réalisation d'espaces vides (6) fermés hermétiquement en utilisant un corps de couverture surfacique (4) en verre,
**caractérisé en ce que** :
sur une plaquette en semiconducteur (2) comportant des structures électriques préétablies, un système de couches de passivation (1) se composant d'au moins trois couches différentes est déposé sur la totalité de la surface,
- la première (7) des couches déposées étant propre à adsorber des ions mobiles ;
- la deuxième couche (8), sous forme de couche médiane, étant propre à former une barrière vis-à-vis des ions mobiles ;
- la troisième couche (9), située au-dessus, offrant une capacité de liaison anodique ;
ensuite, la plaquette en semiconducteur (2) et le corps de couverture surfacique (4) sont assemblés par réalisation d'une liaison anodique, moyennant la présence dudit système de couches de passivation (1 ; 7, 8, 9) entre les plaquettes à relier (2, 4) ; et au moins un espace vide (6) ménagé dans le corps de couverture (4) est sensiblement fermé hermétiquement au-dessus de la troisième des trois couches.

2. Procédé selon la revendication 1, dans lequel le dépôt des couches du système de couches de passivation (1) a lieu sur une couche d'isolateur qui a été produite au cours d'étapes de processus précédentes.

3. Procédé selon la revendication 1, dans lequel le corps de couverture surfacique (4) est une plaquette de couverture en verre.

4. Procédé selon la revendication 1, dans lequel le corps surfacique plan de couverture (4) est ouvert (10) dans la zone d'au moins une plage de connexion (5) et seules des bordures de la plage de connexion sont recouvertes.

5. Procédé selon la revendication 4, dans lequel, en dehors des plages de connexion (5), le corps surfacique de couverture (4) est collé au-dessus du système de couches (1) servant à réaliser la passivation et il protège (A, B) des structures électriques (3) situées sous le système de couches (1).

6. Procédé selon la revendication 1, dans lequel une couche isolante est appliquée entre les structures électriques (3) et le système de couches de passivation (1) avant que la première couche (7) du système de couches (1) soit déposée.

7. Procédé selon la revendication 1, dans lequel il est prévu une couche de nitrure de silicium (8) servant à régler une tension de couche définie, et/ou dans lequel la troisième couche (9) du système de couches (1) est une couche d'oxyde, déposée chimiquement en phase vapeur, produite au moyen d'un procédé à TEOS (orthosilicate de tétraéthyle).

8. Système de couches de passivation pouvant être fabriqué selon la revendication 1 et destiné à un microsystème électromécanique comportant des structures de commutation (3), le système de couches comportant trois couches placées les unes au-dessus des autres : une première couche (7), située juste à côté des structures de commutation (3), en verre de phosphosilicate ; une couche médiane (8) en nitrure de silicium ; et une troisième couche (9) en oxyde de silicium permettant de réaliser une liaison anodique hermétiquement étanche entre une plaquette de couverture (4) et la couche supérieure du système de couches.

9. Système de couches de passivation selon la revendication 8, dans lequel la troisième couche est une couche d'oxyde déposée chimiquement en phase vapeur qui a été produite au moyen d'un procédé à TEOS.

10. Système de couches de passivation selon la revendication 8, dans lequel la couche de nitrure de silicium est prévue pour régler une tension de couche définie.
